(19) Europäisches Patentamt / European Patent Office / Office européen des brevets

(11) **EP 3 665 459 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**26.03.2025   Patentblatt 2025/13**

(45) Hinweis auf die Patenterteilung:
**12.01.2022   Patentblatt 2022/02**

(21) Anmeldenummer: **18759239.9**

(22) Anmeldetag: **07.08.2018**

(51) Internationale Patentklassifikation (IPC):
**G01L 9/00** (2006.01)    **G01L 23/10** (2006.01)
**G01P 15/09** (2006.01)    **G01L 1/16** (2006.01)
**G01L 1/26** (2006.01)    **H01L 41/053** (2006.01)

(52) Gemeinsame Patentklassifikation (CPC):
**G01L 1/26; C04B 35/583; G01L 1/16; G01L 9/0052; G01L 9/008; G01L 23/10; G01P 15/09; H10N 30/302; H10N 30/88;** C04B 2235/3244; C04B 2235/3409; C04B 2235/3418; C04B 2235/3826; C04B 2235/428; C04B 2235/72;    (Forts.)

(86) Internationale Anmeldenummer:
**PCT/AT2018/060182**

(87) Internationale Veröffentlichungsnummer:
**WO 2019/028488 (14.02.2019 Gazette 2019/07)**

(54) **PIEZOELEKTRISCHE VORRICHTUNG MIT ZUMINDEST EINEM PIEZOELEKTRISCHEN ELEMENT**

PIEZOELECTRIC DEVICE HAVING AT LEAST ONE PIEZOELECTRIC ELEMENT

DISPOSITIF PIÉZOÉLECTRIQUE MUNI D'AU MOINS UN ÉLÉMENT PIÉZOÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.08.2017   AT 506562017**

(43) Veröffentlichungstag der Anmeldung:
**17.06.2020   Patentblatt 2020/25**

(73) Patentinhaber: **Piezocryst Advanced Sensorics GmbH**
**8020 Graz (AT)**

(72) Erfinder:
- **SCHRICKER, Alexander**
  **8045 Graz (AT)**
- **NEUBAUER, Christian**
  **8010 Graz (AT)**
- **MAYER, Andreas**
  **A-8113 St. Ostwald bei Plankenwarth (AT)**

(74) Vertreter: **Babeluk, Michael**
**Florianigasse 26/3**
**1080 Wien (AT)**

(56) Entgegenhaltungen:
AT-B- 371 255          CN-A- 104 817 326
DE-A1- 10 217 164    DE-A1- 3 824 849
JP-A- 2013 174 553    JP-A- S59 216 028
US-A- 2 988 728        US-A- 4 052 628

- "Taschenbuch der Physik", 1 January 1990, CARL VERLAG, article KUCHLING HORST: "Tabelle 9", pages: 26 - 27, 614-615
- "Piezoelectric Sensorics", 1 January 2002, SPRINGER, article GAUTSCHI GUSTAV: "Chaters 1, 2 and 3", pages: 1 - 38
- ANONYMOUS: "Silica - Silicon Dioxide (SiO2)", AZO MATERIALS, 13 December 2001 (2001-12-13), Retrieved from the Internet <URL:https://www.azom.com/properties.aspx?ArticleID=1114> [retrieved on 20221024]
- ANONYMOUS: "Infomaterial", METALLGUSS MERTENS USINGEN, 7 February 2016 (2016-02-07), pages 1 - 33, Retrieved from the Internet <URL:http://www.alu-guss.de/Metallguss_Mertens_Usingen_Infomaterial.pdf> [retrieved on 20221024]

EP 3 665 459 B2

(52) Gemeinsame Patentklassifikation (CPC): (Forts.)
C04B 2235/728; C04B 2235/767

**Beschreibung**

Die Erfindung betrifft eine piezoelektrische Vorrichtung mit zumindest einem piezoelektrischen Element, welches eine zu einem Krafteinleitelement ausgerichtete Auflageebene aufweist, wobei bei einer thermischen Belastung der piezoelektrischen Vorrichtung in der Auflageebene Ausdehnungsunterschiede zwischen dem piezoelektrischen Element und dem Krafteinleitelement auftreten, wobei zwischen dem piezoelektrischen Element und dem Krafteinleitelement mindestens ein Übergangselement angeordnet ist.

Bei Kraftmesselementen, Drucksensoren, Beschleunigungs- und Scherkraftsensoren die piezoelektrische Kristallelemente aufweisen, tritt eine Eigenschaft dieser Materialien negativ zutage, nämlich Ausdehnungsunterschiede zu angrenzenden Materialien bei thermischer Belastung, sowie die Anisotropie einiger Stoffwerte, wie Wärmedehnung oder Querdehnung unter mechanischer Spannung.

An das eigentliche piezoelektrische Messelement schließt praktisch immer ein Gehäuse, ein Auflager, ein Druckstempel bzw. ein krafteinleitendes Element an, wobei bei diesen Bauteilen ein Wärmedehnverhalten oder Anisotropien in vergleichbarer Größe, wie bei vielen der in Frage kommenden Piezokristallen kaum zu finden sind. Insbesondere im Übergangsbereich vom anisotropen Kristallelement zum isotropen Auflager treten daher schädliche Scherkräfte und Scherspannungen auf. Einerseits kann dadurch das Kristallelement beim Aufheizen aufgrund der größeren Dehnung des Auflagermaterials zerreißen, andererseits erfolgt ein Rutschen des Kristallelements über die Auflage entlang der Kristallrichtung mit größeren Dehnung und ein anschließendes Zerreißen des Kristallelements beim Abkühlen.

Bei der Erwärmung oder Abkühlung unter Druckbelastung bzw. Vorspannung kommt es zum reibungsbehafteten Gleiten der Bauteile aufeinander oder zu starken Verspannungen sowohl des Auflagers als auch des Messelementes, da isotropes und anisotropes Material bestenfalls in einer Richtung dehnungsangepasst sein können. Meist wurde bisher das Material eines Druckstückes oder Auflagers so gewählt, dass sein Wärmedehnungskoeffizient ebenso wie sein Querdehnungskoeffizient zwischen den jeweiligen Extremwerten des Kristallelements - gemessen in der Ebene der Kontaktfläche - liegt, sodass auf diese Weise eine gewisse Beschränkung der Verspannungen bzw. der Gleitvorgänge erreicht werden konnte.

Die durch die Anisotropie und das unterschiedliche Wärmedehnverhalten hervorgerufenen Spannungen können zur Zerstörung des Auflagers oder des piezoelektrischen Kristallelements führen, letzteres vor allem bei scheibenförmigen Messelementen, angeordnet in Stapeln mit mehreren Messelementen, wie sie bei der Nutzung des sogenannten longitudinalen Piezoeffektes (Ladungsabnahme erfolgt in der Druckfläche) verwendet werden. Die über die Auflage- bzw. Kontaktflächen anliegenden Reibungskräfte wirken hier auf einen normal zu diesen Kräften verhältnismäßig geringen Querschnitt der Kristallelemente, was zum Bruch der Messelemente bei thermischer Wechselbelastung führen kann.

Weiters wird durch Verspannungen des Kristalls auch dessen Ladungsabgabe, d.h. das Messsignal beeinflusst. Beispielsweise kann es in Teilen der Druckfläche zwischen Kristallelement und Auflager zu reibungsbehaftetem Gleiten und damit zu Hystereseerscheinungen im Messsignal kommen, die natürlich vermieden werden müssen.

Im Zusammenhang mit dieser Problematik wird in der DE 196 51 227 A1 vorgeschlagen, das piezoelektrische Messelement oder die dem piezoelektrischen Messelement zugekehrten Endbereiche beider Auflager in mehrere stab-, rollen- oder stegförmige Elemente zu unterteilen, wobei die beiden Auflager und das piezoelektrische Messelement in Längsrichtung der stab-, rollen- oder stegförmigen Elemente normal auf die Richtung der Krafteinleitung im Wesentlichen dieselbe Wärmedehnung oder Querdehnung aufweisen. Beseitigt bzw. minimiert werden die genannten Probleme somit durch eine "anisotrope Bauform" des Messelementes bzw. des Auflagers.

Beispielsweise weisen die dem piezoelektrischen Messelement zugekehrten Endbereiche beider Auflager aus einem isotropen Material stegförmige Elemente oder Rollen auf, deren Wärme- und Querdehnung in Längsrichtung an jene des piezoelektrischen Messelementes angepasst ist. Die Fertigung derartiger Endbereiche ist allerdings aufwändig und die Anpassung der Wärme- und Querdehnung in Längsrichtung für viele Materialkombinationen nicht möglich.

Ein anderer Lösungsansatz wird in der DE 102 17 164 B4 bzw. in deren Offenlegungsschrift DE 102 17 164 A1 beschrieben. Zur besseren Anpassung der thermischen Ausdehnung im Bereich der Kontaktflächen ist hier zu beiden Seiten des piezoelektrischen Elementes (z.B. aus $GaPO_4$) in Zwischenlage zum jeweiligen Auflageelement ein Anpassungselement angeordnet. Jedes der Anpassungselemente (z.B. ebenfalls aus $GaPO_4$) weist zumindest in der Ebene seiner beiden Kontaktflächen eine anisotrope thermische Ausdehnung auf, welche in der Richtung der maximalen Ausdehnungsunterschiede (beispielsweise in Richtung der z-Achse des piezoelektrischen Elementes) zwischen jener des piezoelektrischen Elementes und des isotropen Auflageelementes liegt.

Der Ausgleich der unterschiedlichen thermischen Ausdehnung wird beispielsweise in der DE 102 17 164 A1 mit Hilfe von Anpassungselementen erreicht, deren optische z-Achse in Bezug auf die Kontaktflächen um einen bestimmten Winkel gekippt bzw. um die y-Achse gedreht ist. Die thermische Ausdehnung in Richtung der Projektion (Projektion der z-Achse auf die Kontaktfläche) liegt zwischen jener des piezoelektrischen Elementes in Richtung z-Achse und jener der isotropen Auflage. Weiters ist die Projektion der optischen z-Achse des Anpassungselementes parallel oder antiparallel zur optischen z-Achse des piezoelektrischen Elementes ausgerichtet.

Dieser Lösungsansatz ist jedoch aufwändig und lässt sich nicht immer erfolgreich umsetzen, zumal bisher die Meinung vorherrschte, dass das Auflager möglichst hart ausgeführt sein muss. Typische Materialien für das Auflager waren bisher Nickel-Basiswerkstoffe oder isolierende Keramiken (z.B. $Al_2O_3$) oder Saphir.

Aufgabe der vorliegenden Erfindung ist es, die eingangs beschriebenen piezoelektrischen Vorrichtungen derart zu verbessern, dass Scherspannungen und Scherkräfte in den Bereichen zwischen den krafteinleitenden Elementen und dem piezoelektrischen Messelement mit möglichst einfachen Maßnahmen minimiert bzw. weitgehend vermieden werden. Weiters soll die Qualität des Messsignals verbessert werden, wobei insbesondere spontan auftretende Fehlsignale, hervorgerufen durch reibungsbehaftetes Gleiten und Rutschen der piezoelektrischen Elemente an deren Auflagen, vermieden werden soll.

Erfindungsgemäß wird dies dadurch erreicht, dass das Übergangselement einen E-Modul aufweist, dessen E-Modul-Komponenten $c_{22}$, $c_{33}$ in der Auflageebene jeweils kleiner sind, als die entsprechenden E-Modul-Komponenten des piezoelektrischen Elements. Dadurch "dehnt" oder "staucht" das piezoelektrische Element das Übergangselement. Es reduzieren sich daher im piezoelektrischen Element die Spannungswerte, die das piezoelektrische Element schädigen oder zerreißen könnten.

Im Unterschied zu der aus der DE 102 17 164 A1 bekannten Problemlösung (Anpassung der thermischen Ausdehnungskoeffizienten), werden bei der Erfindung unerwünschte Scherspannungen und Scherkräfte in der Auflageebene mit Hilfe eines Übergangselements minimiert, dessen Elastizitätsmodul die in Anspruch 1 dargelegten Merkmale aufweist.

Erfindungsgemäß kann bei einer piezoelektrischen Vorrichtung, das zumindest eine piezoelektrische Element eine anisotrope thermische Ausdehnung und einen durch einen Elastizitätstensor $E^K$ beschreibbaren, anisotropen E-Modul aufweisen. Dabei ist der E-Modul des Übergangselements kleiner als die der Auflageebene zugeordneten Komponenten $c_{22}$ und $c_{33}$ des Elastizitätstensors $E^K$.

Falls auch das Übergangsmaterial, beispielsweise ein Sinterkörper, einen anisotropen E-Modul aufweist, der durch einen Elastizitätstensor $E^Ü$ beschreibbar ist, mit

$$E^K = \begin{bmatrix} c_{11} & & \\ & c_{22} & \\ & & c_{33} \end{bmatrix} \qquad E^Ü = \begin{bmatrix} c_{11} & & \\ & c_{22} & \\ & & c_{33} \end{bmatrix}$$

so gilt $c_{22}$ ($E^K$) > $c_{22}$ ($E^Ü$) und $c_{33}$ ($E^K$) > $c_{33}$ ($E^Ü$). Die Komponente $c_{11}$ des Elastizitätstensors betrifft eine Richtung (x-Richtung) normal auf die Auflageebene (y-z-Ebene) und hat keinen Einfluss auf die Ausdehnungsunterschiede in der Auflageebene.

Zur möglichst verlustfreien Übertragung der Druckkräfte in das piezoelektrische Element weist das Übergangselement in Richtung einer auf das piezoelektrische Element einwirkenden Kraft eine Druckfestigkeit von zumindest 30%, vorzugsweise von über 90%, der Druckfestigkeit des piezoelektrischen Elements auf.

Überraschenderweise hat sich gezeigt, dass die geforderten Materialeigenschaften für das Übergangselement (kleiner E-Modul bei gleichzeitig hoher Druckfestigkeit) von einem Sintermaterial erfüllt werden, das großteils (ca. 50% bis 70%) aus gesintertem, hexagonalem Bornitrid besteht (Bezugsquelle: z.B.: HENZE Boron Nitride Products, siehe: www.henze-bnp.de).

Das Übergangselement aus Bornitrid kann in der piezoelektrischen Vorrichtung mit seinem spezifischen elektrischen Widerstand > $10^{12}$ Ohm cm gleichzeitig als elektrisches Isolierelement eingesetzt werden.

Beispielsweise gilt für $GaPO_4$ und einen BN Sinterwerkstoff für den anisotropen E-Modul [GPa]

$$E^{GaPO_4} = \begin{bmatrix} 67 & & \\ & 67 & \\ & & 102 \end{bmatrix} \qquad E^{BN} = \begin{bmatrix} 45 & & \\ & 45 & \\ & & 30 \end{bmatrix}$$

Der E-Modul eines Übergangselementes aus gesintertem hexagonalem Bornitrid, Siliciumcarbid und Zirconuim(IV)oxid liegt zwischen 30 GPa und 45 GPa bei einer Druckfestigkeit von über 100 MPa. Der E-Modul von $GaPO_4$ liegt in der Auflageebene bei viel größeren Werten, nämlich in der y-Achse bei 67 GPa und in der z-Achse bei über 100 GPa, sodass der $GaPO_4$-Kristall das Übergangselement stauchen oder dehnen kann, ohne zu brechen. Die Einsatztemperatur des Sintermaterials reicht bis 900°C in oxidierenden Atmosphären und bis 1800°C in inerten Atmosphären. Es ist daher für piezoelektrischen Vorrichtungen (z.B. für Drucksensoren) im Hochtemperaturbereich über 600°C, sowie in speziellen Anwendungen bis über 800°C, bestens geeignet.

Das Übergangselement besteht großteils (ca. 50% bis 70%) aus gesintertem, hexagonalem Bornitrid (hBN) und kann Anteile an Siliciumcarbid (SiC), Zirconuim(IV)oxid ($ZrO_2$) und/oder Siliciumoxid ($SiO_2$) enthalten. Weiters kann als Bindemittel Boroxid enthalten sein, sowie Spuren von Silicium und Borsäure.

Das Übergangselement kann zusammen mit dem piezoelektrischen Element vorgespannt sein, um Scherkräfte normal zur Vorspannrichtung aufzunehmen.

Beispielhafte Angaben zu geeigneten Materialien für das Übergangselement:

1) Sinterkörper aus ca. 70% hBN, ca. 20% $ZrO_2$, ca. 10% SiC samt Spuren von Si und Borsäure.

2) Sinterkörper aus ca. 50% hBN, ca. 43% $ZrO_2$, ca. 7% SiC samt Spuren von Si und Borsäure.

3) Sinterkörper aus ca. 60% hBN, ca. 40% $SiO_2$ samt Spuren von Borsäure.

Es ist auch möglich ein Übergangselement mit einem anisotropen E-Modul (beispielsweise hexagonales Bornitrid mit anisotropem E-Modul), derart zu orientieren, dass die anisotrope thermische Ausdehnung des piezoelektrischen Elementes in dessen Auflageebene optimal kompensiert wird.

Das piezoelektrische Element kann beispielsweise aus $GaPO_4$, Langasit, Langatat oder Turmalin bestehen oder aus einer Piezokeramik, beispielsweise aus Bismuthtitanat.

Die Erfindung wird im Folgenden an Hand von Ausführungsbeispielen näher erläutert. Es zeigen:

Fig. 1    eine erfindungsgemäße piezoelektrische Vorrichtung in einer schematischen, dreidimensionalen Darstellung;

Fig. 2    eine erste Ausführungsvariante der Erfindung anhand eines Drucksensors (longitudinaler Piezoeffekt) in einer teilweisen Schnittdarstellung;

Fig. 3    eine zweite Ausführungsvariante der Erfindung anhand eines Kraftoder Beschleunigungssensor in einer seitlichen Ansicht;

Fig. 4    eine dritte Ausführungsvariante der Erfindung anhand eines Drucksensors (transversaler Piezoeffekt) in einer teilweisen Schnittdarstellung;

Fig. 5    eine vierte Ausführungsvariante der Erfindung anhand eines Beschleunigungs- oder Vibrationssensor in einer dreidimensionalen Darstellung; sowie

Fig. 6    eine vereinfachte Seitenansicht der vierten Ausführungsvariante.

Funktionsgleiche Teile sind in den Ausführungsvarianten mit gleichen Bezugszeichen versehen.

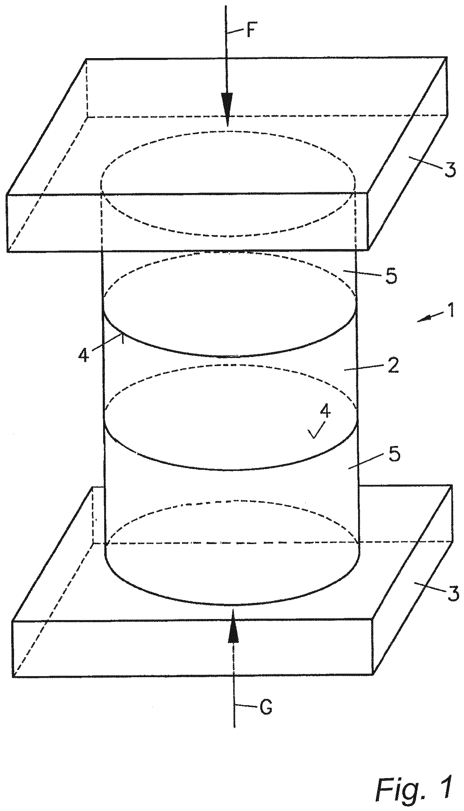

Die in Fig. 1 schematisch dargestellte piezoelektrische Vorrichtung 1 weist zumindest ein piezoelektrisches Element 2, beispielsweise ein Kristallelement aus $GaPO_4$, auf, welches in seinen parallelen, zu den beiden Krafteinleitelementen 3 ausgerichteten Auflageebenen 4 eine anisotrope thermische Ausdehnung aufweist, derart, dass bei einer thermischen Belastung der piezoelektrischen Vorrichtung 1 in den Auflageebenen 4 Ausdehnungsunterschiede zwischen dem piezoelektrischen Element 2 und den Krafteinleitelementen 3 auftreten. Zur Minimierung bzw. Kompensation von Scherkräften und Scherspannungen, die beim Erhitzen oder Abkühlen der Vorrichtung 1 auftreten, ist zwischen dem piezoelektrischen Element 2 und den Krafteinleitelementen 3 jeweils ein Übergangselement 5 angeordnet, dessen E-Modul kleiner ist als der E-Modul des piezoelektrischen Elements 2 in dessen Auflageebene 4. Scherspannungen im piezoelektrischen Element 2 werden somit durch Dehnung oder Stauchung des Übergangelements 5 abgebaut und erreichen keine Werte, die zu einer Beschädigung des piezoelektrischen Elements 2 führen können. Mit F wird die auf das obere Krafteinleitelement 3 wirkende Kraft und mit G die vom unteren Krafteinleitelement 3 (beispielsweise ein Auflager oder Gehäuseteil) resultierende Gegenkraft bezeichnet.

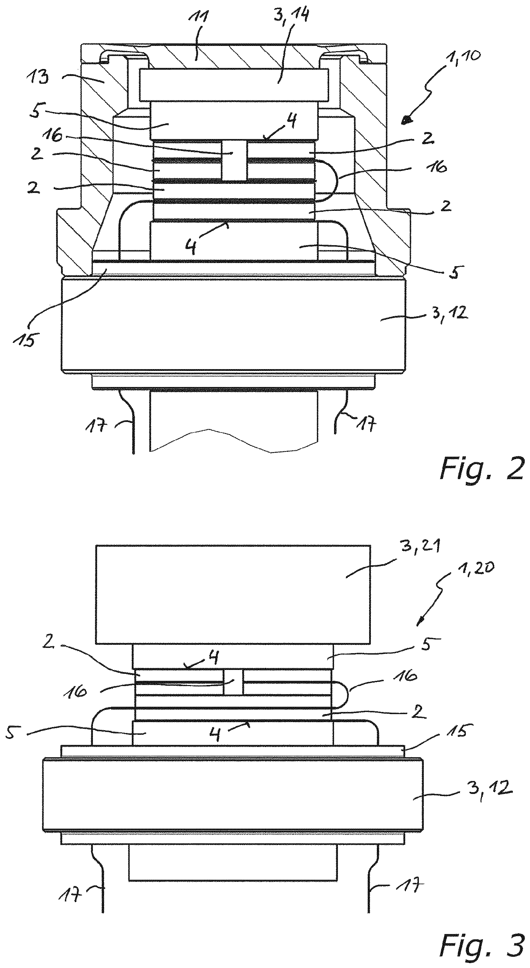

Die in Fig. 2 dargestellte Ausführungsvariante der Erfindung zeigt einen Drucksensor 10 mit einer Sensormembran 11, wobei das untere Krafteinleitelement 3 als Auflager 12 des Sensors 10 ausgeführt ist. Das obere Krafteinleitelement 3 ist als von der Sensormembran 11 beaufschlagtes Druckstück 14 ausgebildet, wobei zwischen dem Auflager 12 und dem unteren piezoelektrischen Element 2 eines Stapels von z.B. vier Piezoelementen 2 ein erstes, scheibenförmiges Übergangselement 5 und zwischen dem oberen, membranseitigen piezoelektrischen Element 2 und dem Druckstück 14 ein zweites, scheibenförmiges Übergangselement 5 angeordnet ist, sodass die in den kritischen Auflageebenen 4 der randseitigen Piezoelemente 2 auftretenden Scherspannungen und Scherkräfte wirksam kompensiert werden können. Der zentrale Bereich der Membran 11 kann auch direkt am membranseitigen Übergangselement 5 anliegen.

Der Durchmesser des Übergangselements entspricht im Wesentlichen dem Durchmesser der piezoelektrischen Elemente, wobei die piezoelektrische Vorrichtung gemäß Fig. 2 dazu ausgebildet ist, den longitudinalen Piezoeffekt des piezoelektrischen Elements zur Bestimmung einer Größe zu verwenden. Die Dicke des Übergangselements 5 kann je nach Anwendungsfall zwischen 20% und 500%, vorzugsweise zwischen 50% und 300%, der Dicke des in einem Stapel angeordneten piezoelektrischen Elements 2 betragen. Eine dünne Beschichtung der piezoelektrischen Elemente 2, beispielsweise aus Bornitrid, ist jedenfalls nicht geeignet, die eingangs beschriebenen Scherkräfte zu kompensieren.

Das Gehäuse des Drucksensors 10 ist mit dem Randbereich der Sensormembran 11 verschweißt und an einem Zentrierflansch 15 des Auflagers 14 befestigt.

Die Übergangselemente 5 dienen gleichzeitig als elektrische Isolierelemente. Gleichnamige Ladungen an den piezoelektrischen Elementen werden über dünne, duktile Elektrodenbleche 16 aus einem Folienmaterial gesammelt und mittels Signalleitungen 17 abgeleitet. In den Fig. 2 und Fig. 3 sind nur die Verbindungsschlaufen der Elektrodenbleche 16 erkennbar.

Die in Fig. 3 dargestellte Ausführungsvariante der Erfindung zeigt einen Kraft- oder Beschleunigungssensor 20 wobei das untere Krafteinleitelement 3 als Auflager 12 des Sensors 20 ausgeführt ist. Das obere Krafteinleitelement 3 ist als seismische Masse 21 ausgebildet, wobei zwischen dem Auflager 12 und dem unteren piezoelektrischen Element 2 eines Stapels von z.B. vier Piezoelementen 2 ein erstes Übergangselement 5 und zwischen dem oberen piezoelektrischen Element 2 und der seismischen Masse 21 ein zweites Übergangselement 5 angeordnet ist, sodass auch hier die in den kritischen Auflageebenen 4 der randseitigen Piezoelemente 2 auftretenden Scherspannungen und Scherkräfte wirksam kompensiert werden können. Die beiden Übergangselemente 5 und die dazwischen angeordneten piezoelektrischen Elemente 2 sind ringförmig ausgebildet, um ein am Auflager 12 und an der seismischen Masse 21 angreifendes Vorspannelement (nicht dargestellt) aufzunehmen.

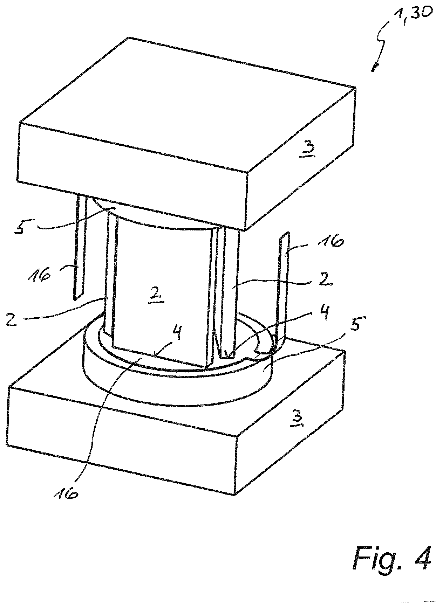

Die in Fig. 4 dargestellte Ausführungsvariante eines Drucksensors 30 entspricht im Wesentlichen der Variante gemäß Fig. 2, wobei hier die piezoelektrischen Elemente 2 quaderförmig ausgebildet und unter Nutzung des transversalen Piezoeffektes stehend angeordnet sind. Das Sensorgehäuse sowie die Sensormembran wurden zur besseren Übersicht weggelassen. Die Dicke des Übergangselements 5 beträgt zwischen 5% und 200%, vorzugsweise zwischen 10% und 50%, der Höhe des stehend angeordneten piezoelektrischen Elements 2.

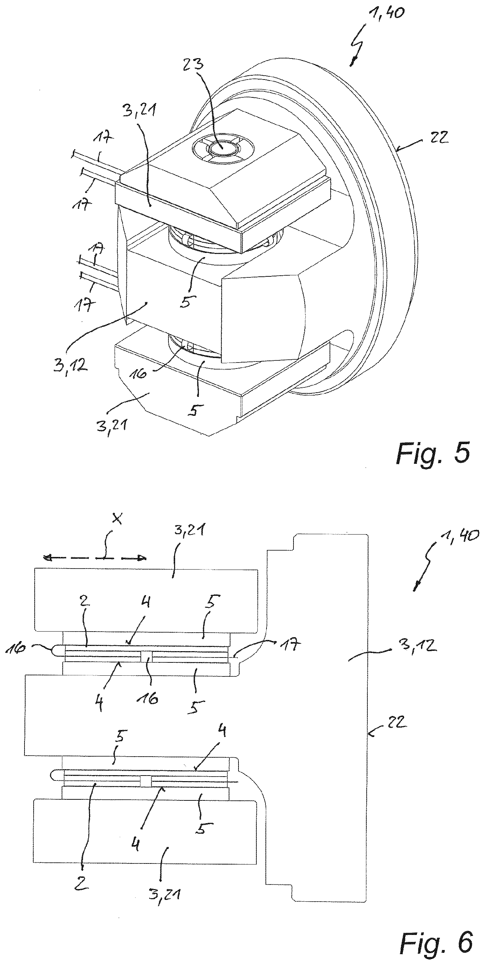

Die in den Fig. 5 und Fig. 6 dargestellte Ausführungsvariante der Erfindung zeigt einen Kraft- oder Beschleunigungssensor 40, wobei ein zentrales, beispielsweise T-förmiges Krafteinleitelement 3 als Auflager 12 des Sensors 40 ausgeführt ist und eine Montagefläche 22 zur Befestigung an einem hier nicht weiter dargestellten Bauteil aufweist. Zwei seitlich angeordnete Krafteinleitelemente 3 sind als seismische Massen 21 ausgebildet, wobei zwischen jeder seismischem Masse 21 und dem Auflager 12 jeweils ein Stapel mit piezoelektrischen Elementen 2 angeordnet ist und die jeweils äußeren piezoelektrischen Elemente 2 jedes Stapels unter Zwischenlage eines Übergangselementes 5 am Auflager 12 bzw. an den seismischen Massen 21 anliegen. Die vier Übergangselemente 5 und die dazwischen angeordneten piezoelektrischen Elemente 2 sind beispielsweise ringförmig ausgebildet, um ein am Auflager 12 und den beiden seismischen Massen 21 angreifendes Vorspannelement 23 aufzunehmen. Die Vorrichtung eignet sich beispielsweise zur Erfassung von Scher- und Vibrationskräften, die in der Messrichtung x auftreten und eine Scherbelastung in die Übergangselemente 5 einleiten (siehe Fig. 6).

Die elektrische Kontaktierung erfolgt über dünne Elektrodenbleche 16 aus einem Folienmaterial.

**Patentansprüche**

1. Piezoelektrische Vorrichtung mit zumindest einem piezoelektrischen Element (2), welches eine zu einem Krafteinleitelement (3) ausgerichtete Auflageebene (4) aufweist, wobei bei einer thermischen Belastung der piezoelektrischen Vorrichtung in der Auflageebene (4) Ausdehnungsunterschiede zwischen dem piezoelektrischen Element (2) und dem Krafteinleitelement (3) auftreten, wobei zwischen dem piezoelektrischen Element (2) und dem Krafteinleitelement (3) mindestens ein Übergangselement (5) angeordnet ist, **dadurch gekennzeichnet, dass** das Übergangselement (5) einen E-Modul aufweist, dessen E-Modul-Komponenten $c_{22}$, $c_{33}$ in der Auflageebene (4) jeweils kleiner sind als die entsprechenden E-Modul-Komponenten des piezoelektrischen Elements (2), wobei das Übergangselement (5) in Richtung einer auf das piezoelektrische Element (2) einwirkenden Kraft eine Druckfestigkeit von zumindest 30% der Druckfestigkeit des piezoelektrischen Elements (2) aufweist.

2. Piezoelektrische Vorrichtung nach Anspruch 1, **dadurch gekennzeichnet, dass** das zumindest eine piezoelektrische Element (2) eine anisotrope thermische Ausdehnung und einen durch einen Elastizitätstensor beschreibbaren anisotropen E-Modul aufweist.

3. Piezoelektrische Vorrichtung nach Anspruch 1 oder 2, **dadurch gekennzeichnet, dass** das Übergangselement (5) in Richtung einer auf das piezoelektrische Element (2) einwirkenden Kraft eine Druckfestigkeit von über 90%, der Druckfestigkeit des piezoelektrischen Elements (2) aufweist.

4.  Piezoelektrische Vorrichtung nach einem der Ansprüche 1 bis 3, **dadurch gekennzeichnet, dass** das Übergangselement (5) zusammen mit dem piezoelektrischen Element (2) vorgespannt ist, um Scherkräfte aufzunehmen.

5.  Piezoelektrische Vorrichtung nach einem der Ansprüche 1 bis 4, **dadurch gekennzeichnet, dass** das Übergangselement (5) großteils, aus gesintertem, hexagonalem Bornitrid besteht.

6.  Piezoelektrische Vorrichtung nach Anspruch 5, **dadurch gekennzeichnet, dass** das Übergangselement (5) Anteile an Siliciumcarbid (SiC), Zirconuim(IV)oxid ($ZrO_2$) und/oder Siliciumoxid ($SiO_2$) enthält.

7.  Piezoelektrische Vorrichtung nach Anspruch 5 oder 6, **dadurch gekennzeichnet, dass** das Übergangselement (5) als Bindemittel Boroxid enthält.

8.  Piezoelektrische Vorrichtung nach einem der Ansprüche 2 bis 7, **dadurch gekennzeichnet, dass** das Übergangselement (5) ein anisotropes E-Modul aufweist, und dahingehend orientiert ist, dass die anisotrope thermische Ausdehnung des piezoelektrischen Elementes (2) in dessen Auflageebene (4) optimal kompensiert ist.

9.  Piezoelektrische Vorrichtung nach einem der Ansprüche 1 bis 8, **dadurch gekennzeichnet, dass** piezoelektrischen Element (2) aus $GaPO_4$, Langasit, Langatat oder Turmalin besteht.

10. Piezoelektrische Vorrichtung nach einem der Ansprüche 1 bis 8, **dadurch gekennzeichnet, dass** piezoelektrischen Element (2) aus einer Piezokeramik, beispielsweise aus Bismuthtitanat besteht.

11. Piezoelektrische Vorrichtung nach einem der Ansprüche 1 bis 10, **dadurch gekennzeichnet, dass** die piezoelektrische Vorrichtung dazu ausgebildet ist den longitudinalen Piezoeffekt des piezoelektrischen Elements (2) zur Bestimmung einer Größe zu verwenden, wobei die Dicke des Übergangselements (5) zwischen 20% und 500%, vorzugsweise zwischen 50% und 300%, der Dicke des in einem Stapel angeordneten piezoelektrischen Elements (2) beträgt.

12. Piezoelektrische Vorrichtung nach einem der Ansprüche 1 bis 10, **dadurch gekennzeichnet, dass** die piezoelektrische Vorrichtung dazu ausgebildet ist den transversalen Piezoeffekt des piezoelektrischen Elements (2) zur Bestimmung einer Größe zu verwenden, wobei die Dicke des Übergangselements (5) zwischen 5% und 200%, vorzugsweise zwischen 10% und 50%, der Höhe des stehend angeordneten piezoelektrischen Elements (2) beträgt.

13. Piezoelektrische Vorrichtung nach einem der Ansprüche 1 bis 12, **dadurch gekennzeichnet, dass** zur Realisierung eines Drucksensors (10) mit einer Sensormembran (11) ein Krafteinleitelement (3) als Auflager (12) des Drucksensors und ein Krafteinleitelement (3) als von der Sensormembran (11) beaufschlagtes Druckstück (14) ausgebildet ist, wobei zwischen dem Auflager (12) und dem piezoelektrischen Element (2) ein erstes Übergangselement (5) und zwischen dem piezoelektrischen Element (2) und dem Druckstück (14) ein zweites Übergangselement (5) angeordnet ist.

14. Piezoelektrische Vorrichtung nach einem der Ansprüche 1 bis 11, **dadurch gekennzeichnet, dass** zur Realisierung eines Kraft- oder Beschleunigungssensors (20) ein Krafteinleitelement (3) als Auflager (12) des Kraft- oder Beschleunigungssensors und ein Krafteinleitelement (3) als seismische Masse (21) ausgebildet ist, wobei zwischen dem Auflager (12) und dem piezoelektrischen Element (2) ein erstes Übergangselement (5) und zwischen dem piezoelektrischen Element (2) und der seismischen Masse (21) ein zweites Übergangselement (5) angeordnet ist.

## Claims

1.  Piezoelectric device having at least one piezoelectric element (2) which has a support plane (4) aligned with a force introduction element (3), wherein expansion differences occur between the piezoelectric element (2) and the force introduction element (3) when the piezoelectric device is thermally loaded in the support plane (4), wherein at least one transition element (5) is arranged between the piezoelectric element (2) and the force introduction element (3), **characterised in that** the transition element (5) has a modulus of elasticity whose modulus of elasticity components $C_{22}$, $C_{33}$ in the support plane (4) are smaller in each case than the respective modulus of elasticity components of the piezoelectric element (2), wherein the transition element (5) has a compressive strength in the direction of a force acting on the piezoelectric element (2) of at least 30 of the compressive strength of the piezoelectric element (2).

**2.** Piezoelectric device according to claim 1, **characterised in that** the at least one piezoelectric element (2) has an anisotropic thermal expansion and an anisotropic modulus of elasticity which can be described by an elasticity tensor.

**3.** Piezoelectric device according to claim 1 or 2, **characterised in that** the transition element (5) has a compressive strength in the direction of a force acting on the piezoelectric element (2) of more than 90%, of the compressive strength of the piezoelectric element (2).

**4.** Piezoelectric device according to one of claims 1 to 3, **characterised in that** the transition element (5) together with the piezoelectric element (2) is pretensioned to absorb shear forces.

**5.** Piezoelectric device according to one of claims 1 to 4, **characterised in that** the transition element (5) consists largely of sintered, hexagonal boron nitride.

**6.** Piezoelectric device according to claim 5, **characterised in that** the transition element (5) contains proportions of silicon carbide (SiC), zirconium(IV) oxide ($ZrO_2$) and/or silicon oxide ($SiO_2$).

**7.** Piezoelectric device according to claim 5 or 6, **characterised in that** the transition element (5) contains boron oxide as a binder.

**8.** Piezoelectric device according to one of claims 2 to 7, **characterised in that** the transition element (5) has an anisotropic modulus of elasticity and is oriented in such a way that the anisotropic thermal expansion of the piezoelectric element (2) is optimally compensated in its support plane (4).

**9.** Piezoelectric device according to one of claims 1 to 8, **characterised in that** the piezoelectric element (2) is made of $GaPO_4$, langasite, langatate or tourmaline.

**10.** Piezoelectric device according to one of claims 1 to 8, **characterised in that** the piezoelectric element (2) consists of a piezoceramic, for example of bismuth titanate.

**11.** Piezoelectric device according to one of claims 1 to 10, **characterised in that** the piezoelectric device is designed to use the longitudinal piezoelectric effect of the piezoelectric element (2) for determining a size, wherein the thickness of the transition element (5) is between 20% and 500%, preferably between 50% and 300%, of the thickness of the piezoelectric element (2) arranged in a stack.

**12.** Piezoelectric device according to one of claims 1 to 10, **characterised in that** the piezoelectric device is designed to use the transversal piezoelectric effect of the piezoelectric element (2) for determining a size, wherein the thickness of the transition element (5) is between 5% and 200%, preferably between 10% and 50%, of the height of the piezoelectric element (2) arranged upright.

**13.** Piezoelectric device according to one of claims 1 to 12, **characterised in that** in order to realize a pressure sensor (10) with a sensor membrane (11), a force introduction element (3) is formed as a support (12) of the pressure sensor and a force introduction element (3) is formed as a thrust piece (14) acted upon by the sensor membrane (11), wherein a first transition element (5) is arranged between the support (12) and the piezoelectric element (2) and a second transition element (5) is arranged between the piezoelectric element (2) and the pressure piece (14).

**14.** Piezoelectric device according to one of claims 1 to 11, **characterised in that** in order to realize a force or acceleration sensor (20), a force introduction element (3) is designed as a support (12) for the force or acceleration sensor and a force introduction element (3) is designed as a seismic mass (21), wherein a first transition element (5) is arranged between the support (12) and the piezoelectric element (2) and a second transition element (5) is arranged between the piezoelectric element (2) and the seismic mass (21).

**Revendications**

**1.** Dispositif piézoélectrique comportant au moins un élément piézoélectrique (2) ayant un plan d'appui (4) aligné sur un élément d'induction de force (3),

> - une sollicitation thermique du dispositif piézoélectrique dans le plan d'appui (4), produisant des différences de dilatation entre l'élément piézoélectrique (2) et l'élément d'induction de force (3),
- au moins un élément transitoire (5) étant prévu entre l'élément piézoélectrique (2) et l'élément d'induction de force (3),

dispositif **caractérisé en ce que**
l'élément transitoire (5) a un module d'élasticité E dont les composantes $C_{22}$, $C_{33}$ dans le plan d'appui (4) sont respectivement plus petites que les composantes correspondantes du module d'élasticité E de l'élément piézoélectrique (2),

- l'élément transitoire (5) a une résistance à la pression d'au moins 30% de la résistance à la pression de l'élément piézoélectrique (2) dans la direction d'une force agissant sur l'élément piézoélectrique (2).

2. Dispositif piézoélectrique selon la revendication 1,
**caractérisé en ce que**
au moins un élément piézoélectrique (2) a une dilatation thermique anisotrope et un module d'élasticité anisotrope descriptible par un capteur d'élasticité.

3. Dispositif piézoélectrique selon la revendication 1 ou 2,
**caractérisé en ce que**
l'élément transitoire (5) a une résistance à la pression supérieure à 90% de la résistance à la pression de l'élément piézoélectrique (2) dans la direction d'une force agissant sur l'élément piézoélectrique (2).

4. Dispositif piézoélectrique selon l'une des revendications 1 à 3,
**caractérisé en ce que**
l'élément transitoire (5) est précontraint avec l'élément piézoélectrique (2) pour recevoir des efforts de cisaillement.

5. Dispositif piézoélectrique selon l'une des revendications 1 à 4,
**caractérisé en ce que**
l'élément transitoire (5) est en grande partie en nitrure de bore, hexagonale, fritté.

6. Dispositif piézoélectrique selon la revendication 5,
**caractérisé en ce que**
l'élément transitoire (5) contient des parties de carbure de silicium (SiC), d'oxyde de zirconium (IV) ($ZrO_2$) et/ou d'oxyde de silicium ($SiO_2$).

7. Dispositif piézoélectrique selon la revendication 5 ou 6,
**caractérisé en ce que**
l'élément transitoire (5) contient de l'oxyde de bore comme liant.

8. Dispositif piézoélectrique selon l'une des revendications 2 à 7,
**caractérisé en ce que**
l'élément transitoire (5) a un module d'élasticité E anisotrope et orienté de façon que la dilatation thermique anisotrope de l'élément piézoélectrique (2) soit compensée de manière optimale dans son plan d'appui (4).

9. Dispositif piézoélectrique selon l'une des revendications 1 à 8,
**caractérisé en ce que**
l'élément piézoélectrique (2) est en $GaPO_4$, Langasite, Langatate ou Tourmaline.

10. Dispositif piézoélectrique selon l'une des revendications 1 à 8,
**caractérisé en ce que**
l'élément piézoélectrique (2) est en une piézocéramique par exemple, en titanate de bismuth.

11. Dispositif piézoélectrique selon l'une des revendications 1 à 10,
**caractérisé en ce que**
le dispositif piézoélectrique est conçu pour utiliser l'effet piézoélectrique longitudinal de l'élément piézoélectrique (2) pour déterminer une dimension,

- l'épaisseur de l'élément transitoire (5) représente entre 20% et 500%, de préférence entre 50% et 300% de l'épaisseur de l'élément piézoélectrique (2) dans un empilage.

12. Dispositif piézoélectrique selon l'une des revendications 1 à 10,
**caractérisé en ce que**
le dispositif piézoélectrique est conçu pour utiliser l'effet piézoélectrique transversal de l'élément piézoélectrique (2) pour déterminer une dimension, l'épaisseur de l'élément transitoire (5) étant comprise entre 5% et 200%, de préférence entre 10% et 50% de la hauteur de l'élément piézoélectrique (2) mis en position debout.

13. Dispositif piézoélectrique selon l'une des revendications 1 à 12,
**caractérisé en ce que**
pour réaliser un capteur de pression (10) avec une membrane de capteur (11), un élément d'induction de force (3) est réalisé comme appui (12) du capteur de pression et l'élément d'induction de force (3) comme pièce de pression (14) sollicitée par la membrane de capteur (11),

- un premier élément transitoire (5) est entre l'appui (12) et l'élément piézoélectrique (2) et un second élément transitoire (5) est entre l'élément piézoélectrique (2) et la pièce de pression (14).

14. Dispositif piézoélectrique selon l'une des revendications 1 à 11,
**caractérisé en ce que**
pour réaliser un capteur d'accélération ou de force (20), un élément d'induction de force (3) est réalisé comme appui (12) du capteur de force ou d'accélération et un élément inducteur de force (3) est réalisé comme masse sismique (21),

- un premier élément transitoire (5) étant prévu entre l'appui (12) et l'élément piézoélectrique (2) et un second élément transitoire (5) étant prévu entre l'élément piézoélectrique (2) et la masse sismique (21).

Fig. 1

Fig. 2

Fig. 3

Fig. 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19651227 A1
- DE 10217164 B4
- DE 10217164 A1